# EUROPEAN PATENT SPECIFICATION

(11) **EP 0 182 254 B1**
(45) Date of publication and mention of the grant of the patent: **09.03.1994**
(21) Application number: 85114372.7
(22) Date of filing: 12.11.1985
(51) Int. Cl.: G09F 9/33

(54) **Dot matrix luminous display**
Punktmatrix-Leuchtanzeige
Matrice à points pour affichage lumineux

(30) Priority: 12.11.1984 JP 171487/84 U; 05.04.1985 JP 51480/85 U
(43) Date of publication of application: 28.05.1986
(73) Proprietor: TAKIRON CO. LTD., Higashi-ku Osaka-shi Osaka 541 (JP)
(72) Inventor: Masanobu, Miura c/o Takiron Co., Ltd., Osaka-shi Osaka (JP)
(74) Representative: EGLI-EUROPEAN PATENT ATTORNEYS

(56) References cited:
- EP-A- 0 042 122
- WO-A-80/01860
- FR-A- 2 512 238
- GB-A- 1 411 199

## Description

The present invention relates to a dot-matrix luminous display comprising a dot matrix display board having an insulating plate; first and second sets of electrodes provided on respective opposite surfaces of said insulating plate; a plurality of light emitting-elements and a plurality of through-holes through which said light emitting-elements are electrically coupled between said electrodes of said first and second sets, respectively; and a member provided over said one surface of said dot matrix display board, said member having a plurality of through-holes formed therein at locations corresponding to locations of said light-emitting elements.

Luminous displays of this type are designed to display desired characters, symbols or patterns in the form of a dot pattern by supplying power to and lighting selected luminous elements arranged in a matrix.

The basic structure of such a matrix display includes upper and lower electrodes arranged in a three-dimensional matrix with an insulating layer sandwiched therebetween, and semiconductor chips disposed at intersections between the upper and lower electrodes.

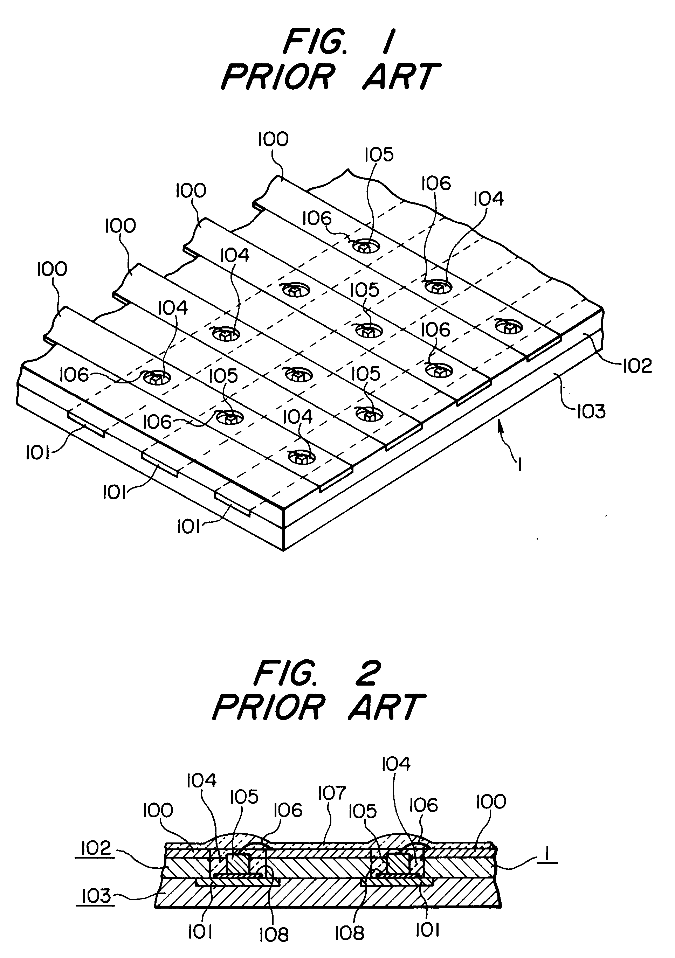

Referring to Figs. 1 and 2, the general structure of such a matrix display will be described. Two sheets of insulating substrates 102 and 103, respectively bearing parallel rows of upper electrodes 100 and lower electrodes 101 on their surfaces, are coupled together to form a matrix luminous display board (hereinafter referred to as simply a "matrix board" or "display board") 1 with the upper and lower electrodes 100 and 101 arranged in a three-dimensional matrix. There are provided through-holes 104 in portions where the upper and lower electrodes 100 and 101 intersect. A semiconductor chip 105, forming a single luminous element, is supplied in each through-hole 104, and, as a final process, the entire surface of the matrix board 1, including the through-holes 104 through which are exposed the semiconductor chips 105, is coated with a translucent thermosetting resin to provide thereby a continuous protective film 107. In addition, bonding wires 106 are used to connect the semiconductor chips 105 to the upper electrodes 100, whereas solder or silver paste 108 is used to provide conductive connection between the bottoms of the semiconductor chips 105 and the lower electrodes 101.

Typically, the spacing between outer edges of adjacent through-holes 104 is about 8.0 mm, the diameter of each through-hole 104 is about 6.5 mm, and the length of a side of the display board 1, is about 64 mm. However, during the process of manufacturing such matrix boards, specifically, when the boards are coated with the translucent thermosetting resin film 107, there may be produced strain, camber, peeling and cracks (hereinafter collectively referred to as "flaws such as strains") at the joints of the matrix board 1 and the protective film 107 because of the difference therebetween in the coefficient of thermal expansion. These flaws such as strains result in defective products.

Moreover, the flaws such as strains become more pronounced as the size of the matrix board 1 is increased. Even finished products are not free from such strains caused by, for instance, the temperature difference between summer and winter or heat generated when power is supplied to the luminous elements.

From WO-A-80/01860 such a kind of matrix board is known, however, providing the disadvantages as discussed above. Therein, on one side of the relatively flexible film of the board a firm grating can be placed. An epoxy is used to fill in the holes in the grating. With the firm and rigid grating and moreover the epoxy filling the holes of the grating, the whole structure will be bent at different rates, producing the above mentioned undesired flows, such as strains in particular at their joints.

The present invention is intended to solve the aforementioned problems.

It is a specific object of the invention to provide a dot matrix luminous display arranged so as to prevent, with a simplified construction, the development of flaws such as strains resulting from the difference in the coefficient of thermal expansion between the above-described materials.

In order to solve the aforementioned problems, the inventive dot matrix luminous display, according to the first part of claim 1 is characterized in that said member is elastic, consists of silicon rubber, neoprene rubber, flexible epoxy resin or flexible acrylic resin, and is flexible relative to that dot matrix display board and that said through-holes of said elastic member being filled with a thermosetting resin, wherein contraction of said thermosetting resin resulting from hardening of said thermosetting resin is absorbed by said rubber member.

As a result, the following functions and effects are provided:
(1) The flexible plate fixed to the surface of the matrix board can be used as part of the protective film for the board, whereby the luminous elements are encapsulated by pouring the translucent thermosetting resin in each through-hole in the flexible plate to protect the luminous elements from the external environment.
(2) The thermosetting resin (forming a protective film for the luminous elements) is prevented from becoming a continuous film when the protective film for the luminous elements is formed, and, because the through-holes are individually filled with the thermosetting resin, the difference in the coefficients of thermal expansion between the matrix board and the thermosetting resin will affect the structure to the least extent.
   Further, the flexible plate can distort and expand freely, due to its inherent flexibility, during the manufacturing process, specifically, when the matrix boards are heated to form protective thermosetting resin films, and consequently the development of flaws such as strains, which may be caused by the undesired effects of shrinkage of the thermosetting resin upon curing, are prevented. Even when the finished products are heated, the development of flaws such as strains is effectively prevented.
   In the dot matrix luminous display according to the present invention, because the formation of flaws such as strain is suppressed, not only has it become possible to improve the manufacturing productivity of these matrix displays, but also the size of the dot matrix luminous displays can be increased.
(3) With the inventive structure, the matrix board with the flexible plate joined thereto can be manufactured inexpensively.
(4) Because the flexible plate joined to the surface of the matrix board has through-holes corresponding in location to the luminous elements and because the protective film is formed by pouring translucent thermosetting resin into the through-holes in the flexible plate when the protective film is formed for the luminous elements, no difficulty occurs in providing the matrix board with a side frame when the protective film is formed, which facilitates the production of such luminous displays.
(5) The flexible plate having through holes has such functions that an occurrence of undesired diffused light and leakage of light to neighboring portions can be positively prevented, a virtual diameter of a dot pattern can be increased and contours of the dot pattern can be made clear whereby the dot mat rix luminous display can be improved in visual characteristics.

Fig. 1 is a perspective view illustrating the basic construction or a dot matrix luminous display;
Fig. 2 is a partially enlarged vertical sectional view of the display of Fig. 1;
Fig. 3 is a schematic exploded view of a matrix board and an flexible plate illustrating a dot matrix luminous display embodying the present invention;
Fig. 4 is an enlarged view of a portion A, in Fig. 3;
Fig. 5 is an enlarged vertical sectional view of the display of Fig.3;
Fig. 6 is a perspective exploded view of another embodiment of the present invention;
Fig. 7 is a diagram illustrating an electrode pattern arranged on the surface of the display board in the Fig. 6 embodiment;
Fig. 8 is a diagram illustrating an electrode pattern arranged on the rear surface thereof;
Fig. 9 is an enlarged top view of a luminous portion;
Fig. 10 is a diagram illustrating an example of an electrical, equivalent circuit of the luminous display board of the Fig. 6 embodiment;
Fig. 11 is an enlarged structural vertical sectional view of the luminous portion corresponding to Fig. 9;
Fig. 12 is an enlarged top view of another luminous portion;
Fig. 13 is a perspective view illustrating another example of a display board to which the present invention is applicable.

### DESCRIPTION OF THE PREFERRED EMBODIMENTS

Referring now to the accompanying drawings, a dot matrix luminous display embodying the present invention will be described.

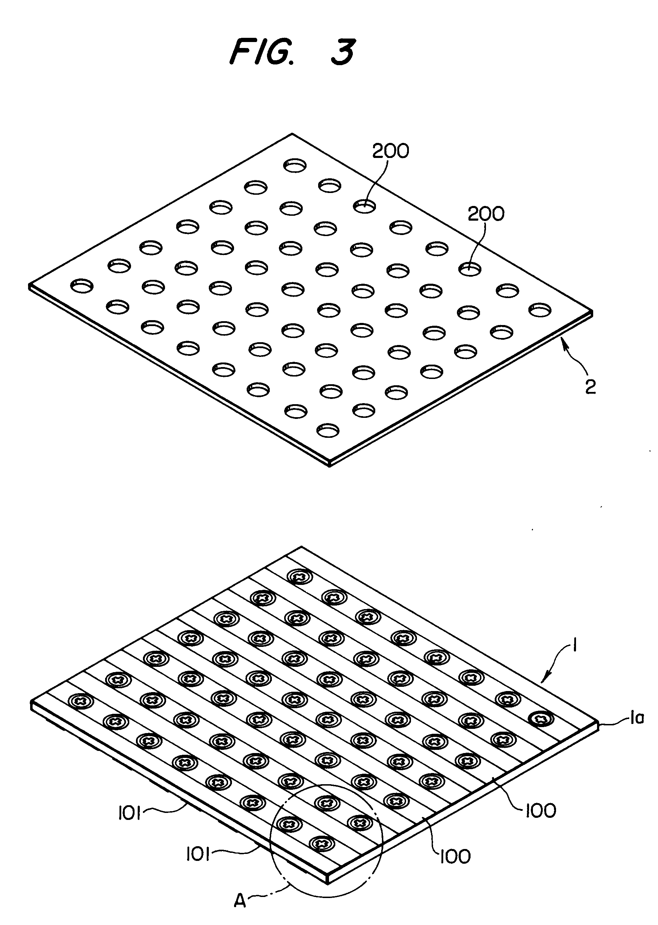

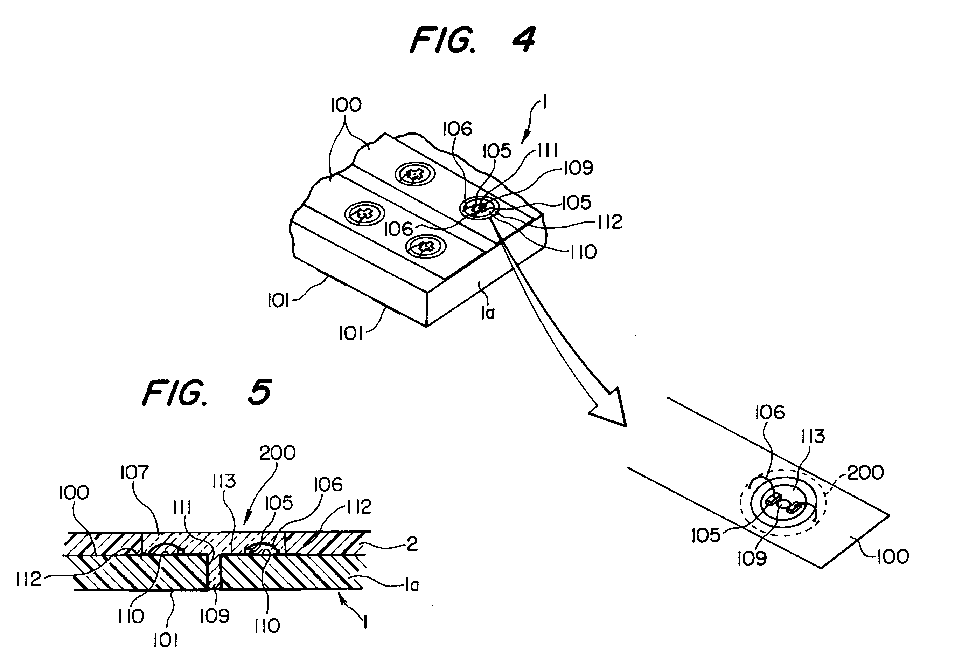

Fig. 3 is a schematic exploded view illustrating a matrix luminous display according to the present invention. Fig. 4 is an enlarged view of a portion A indicated in Fig. 3. Fig. 5 is a vertical sectional view illustrating principal portions with the flexible plate joined.

As shown in these drawings, the luminous display according to the present invention includes the flexible plate 2 with through-holes 200 provided therein joined to the surface of the matrix board 1. The flexible plate 2 is prepared from a flexible material.

To construct this display, first an etching process is applied to the top and bottom faces of a glass epoxy laminated plate, to the top and bottom faces of which have been adhered copper foil, to remove undesired portions of the copper foil so as to provide upper electrodes 100 and lower electrodes 101 arranged in a three-dimensional matrix, including cross conductive portions 111. The cross conductive portions 111 are provided inside respective insulating portions 110, formed in a part of the upper electrode 100 above the lower electrodes 101, and are coupled to the lower electrodes 101 through respective through-holes 109 provided in the center of the insulating portions 110. The surface of each cross conductive portion 111 is plated, and a portion surrounding the cross conductive portion 111 is plated to form a conductive portion 113.

Although a print circuit board having a glass epoxy laminated plate as a substrate is described as the material of the matrix board 1 in this embodiment, the material is not particularly restricted and, for instance, a paper phenol laminated plate lined with copper and a composite plate as shown in Fig. 1 can be used.

The lower surfaces of semiconductor chips 105, used as the luminous elements are fixed with silver paste (not shown) to the conductive portion 113, whereas the upper surfaces of the semiconductor chips 105 are bonded by wires 106 to a plated portion 112 of the upper electrode 100.

Well known types of pn junction light-emitting diodes, such as those of the gallium phosphorus (GaP) type, gallium arsenic (GaAs) type, gallium aluminum arsenic (GaAlAs) type etc., are preferably employed for the semiconductor chips 105 constituting the luminous elements used in the present invention, but other types may be used as well.

As aforementioned, the flexible plate 2 prepared from a flexible material is provided with through-holes 200 at location corresponding to the semiconductor chips 105 arranged on the matrix board 1. The material used to prepare the flexible plate 2 is preferably one of silicon rubber, neoprene rubber, flexible epoxy resin, or flexible acrylic resin, and most preferably a heat resistant material.

It is also preferred to apply white or silver paint to the inside surface of each through-hole 200 to improve the luminous flux radiated from the luminous element 105 and to obtain clearer light emission by preventing light from leaking to neighboring portions. Particularly, it is preferred to form the flexible plate 2 itself of a white material having an excellent light reflection efficiency. Accordingly, the finished dot matrix luminous display thus constructed is obtained by joining the flexible plate 2 to the surface of the matrix board 1, pouring translucent thermosetting resin into each through-hole 200 in the flexible plate 2, then thermosetting the resin to form a protective film 107 (see Fig. 5).

To operate the dot matrix luminous display, positive and negative driver terminals are respectively connected to the upper electrode 100 and the lower electrode 101, and a dynamic drive circuit is used to display desired characters, symbols and patterns in the form of a dot patterns by selectively supplying power to and lighting the luminous elements 105 by the selection of combinations of electrodes, as is well known.

With such a dot matrix luminous display as shown in Figs. 3 through 5, since the portions of the through-holes 109 and 200 coincide with each other, it is preferable to previously fill the through-holes 109 with solder or silver paste in order to prevent the leakage of thermosetting resin to a backside of the display. In order to eliminate the above problem accompanying the display of Figs. 3 through 5, it is considered that the through-holes in the display board are provided in areas other than those where the through-holes in the flexible plate are made.

Another embodiment of the present invention, which is provided with offset through-holes to eliminate the problem accompanying the embodiment of Figs. 3 through 5, will now be described.

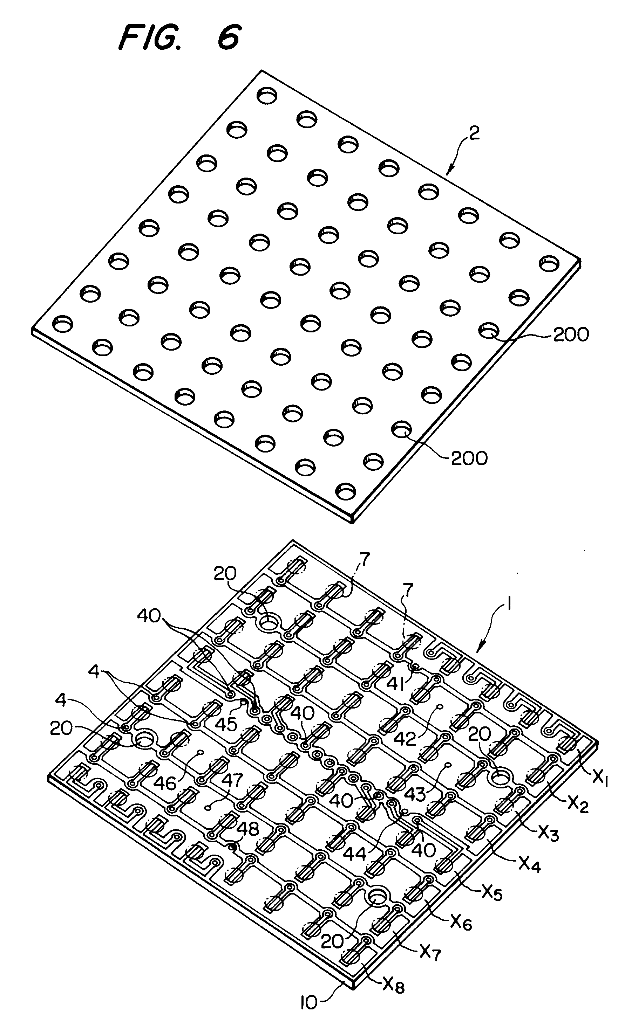

Fig. 6 is a perspective exploded view illustrating an application of the present invention to a 8 x 8 dot matrix luminous display, which includes a display board 1, luminous portions 7 formed by semiconductor chips such as light-emitting diodes, and an flexible plate 2 provided with through-holes 200 corresponding in location to the luminous portions 7.

As shown in Fig. 6, the display board 1 is provided with an electrode pattern (represented by X and Y electrodes in this case), formed by etching the top and bottom faces of a laminated plate lined with copper, and luminous portions 7 including semiconductor chips 7a, such as light-emitting diodes, fixed thereto. The luminous portions 7 are arranged in a matrix.

The following Table 1 shows a concrete example of a 8 x 8 dot matrix luminous display.

**TABLE 1**

| | |
|---|---|
| Side length of display board: | 64 mm |
| Diameter of through holes: | 6.5 mm |
| Spacing between through holes: | 8.0 mm |
| Thickness of matrix board: | 1.6 mm |
| Thickness of flexible plate: | 1.5 to 2.0 mm |

In the dot matrix luminous display plate thus constructed, because no through-holes are present in the display board in the areas of the luminous portions, the above described process of filling these holes is unnecessary when the through-holes in the flexible plate are filled with thermosetting resin. Thus, the manufacturing efficiency of the display is significantly improved.

That is, because the flexible plate has through-holes in locations corresponding to the luminous portions and not the through-holes in the display board, it is only necessary to fill the through-holes in the locations corresponding to the luminous portions with thermosetting resin and to harden the resin. Accordingly, since only those through-holes must be filled with the thermosetting resin, there is little likelihood of leakage from the backside of the display board.

In addition, a concrete example of 16 x 16 dot matrix luminous display is as shown in the following Table 2.

**TABLE 2**

| | |
|---|---|
| Side length of display board: | 64 mm |
| Diameter of through holes : | 3.0 mm |
| Spacing between through holes: | 4.0 mm |
| Thickness of matrix board: | 1.6 mm |
| Thickness of flexible plate: | 1.0 to 1.5 mm |

While two concrete examples are shown in the above Tables 1 and 2, there is no intension to limit the present invention thereto. According to experiments, the fact is established that as the side length of the display board increases, the effect of the present invention becomes remarkable. More specifically, the effect of the present invention is remarkable in case of the side length of the display board larger than 50 mm.

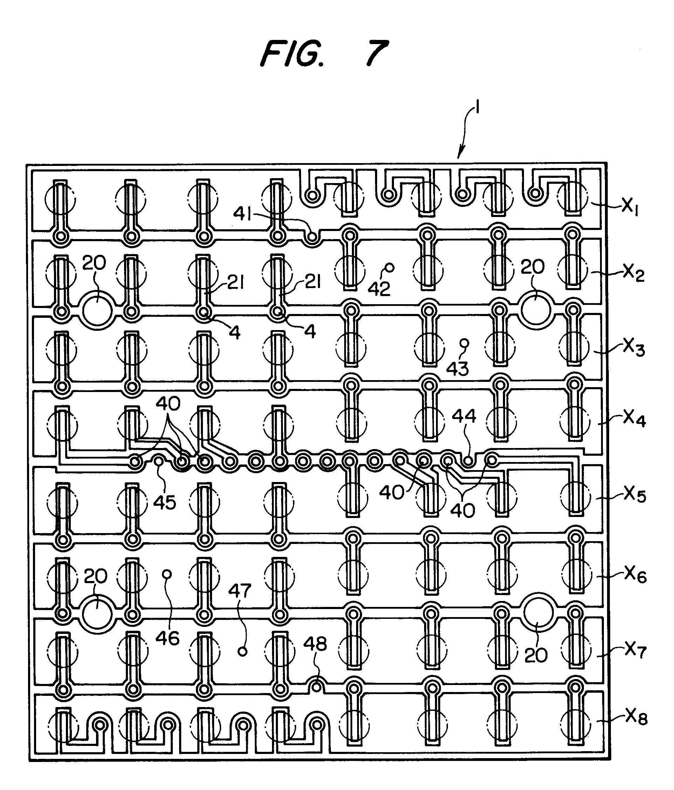

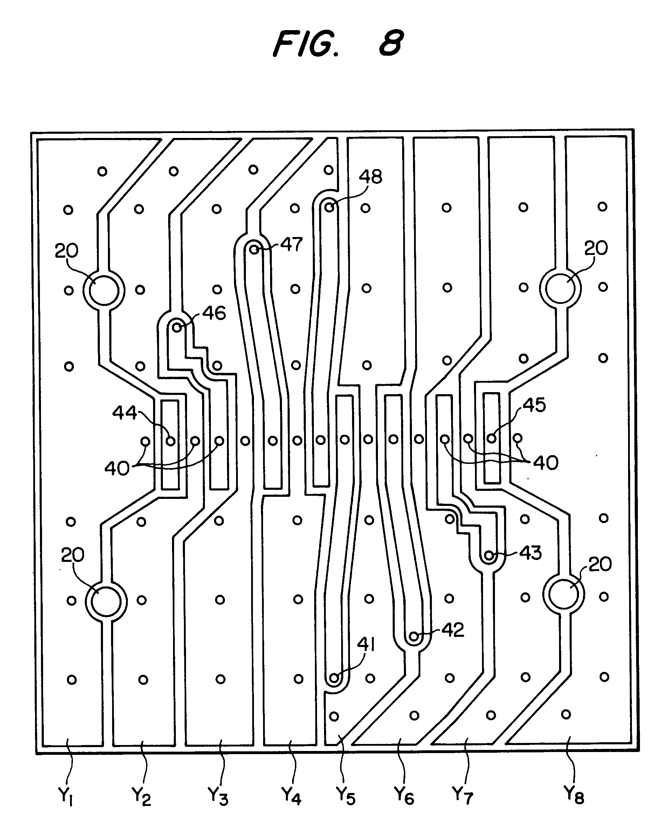

Fig. 7 is a diagram illustrating the electrode pattern arranged on the surface of the display board 1. Fig. 8 is a diagram illustrating the rear side of the electrode pattern.

Referring to Figs. 7 and 8, copper foil attached to the top and bottom faces of a laminated plate is etched to form electrodes X (X₁ to X₈) and Y (Y₁ to Y₈) for the display board 1.

In the center of the display board 1 there are formed sixteen through-holes 40, including through-holes 44 and 45, in a horizontal row where connector terminals are installed. The connector terminals on the electrode X and Y sides are alternately arranged. The connector terminals on the electrode X side are respectively connected to the electrodes X (X₁ to X₈) via through-holes 41 to 48, whereas those on the electrode Y side are respectively connected to vertically extending electrodes 21 via through-holes 4 corresponding to the luminous portions 7.

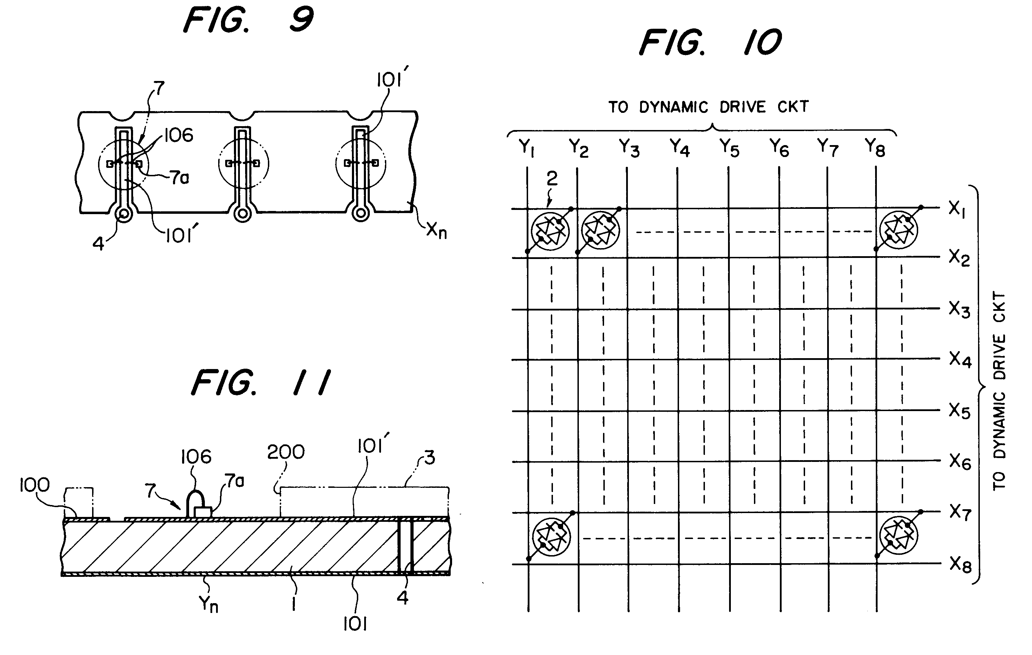

In Figs. 6 through 11 the portions designated by alternate long and short dashed lines are the luminous portions 7 where the semiconductor chips 7a are installed. The luminous portions 7 are conductively plated and supplied with the semiconductor chips 7a by means of silver paste, the semiconductor chips 7a being wire-bonded to the vertically extending electrodes 21. Fig. 9 is an enlarged view of a luminous portion 7 in Fig. 6.

The flexible plate 2 is joined to the display board 1 in such a manner as to match the through-holes 200 thereof to the luminous portions 7 on the display board 1. Each of the through-holes 200 of the flexible plate 2 is filled with thermosetting resin (not shown) to complete the dot matrix luminous display. There are also shown fitting holes 20 in Figs. 6 through 8 used to attach the display board 1 to a matrix drive circuit board(not shown).

To operate the display board 1 thus arranged, a connector (not shown) is fitted to the connected terminal, and then connected to a matrix drive circuit (not shown). The luminous portions 7 are then selectively supplied with power by driving selected combinations of the electrodes X and Y in such a manner that dot patterns in the form of desired characters or symbols are displayed.

Fig. 10 shows an electrical equivalent circuit of the display board 1 with two semiconductor chips 7a (light-emitting diodes) connected to each luminous portion 7 in parallel.

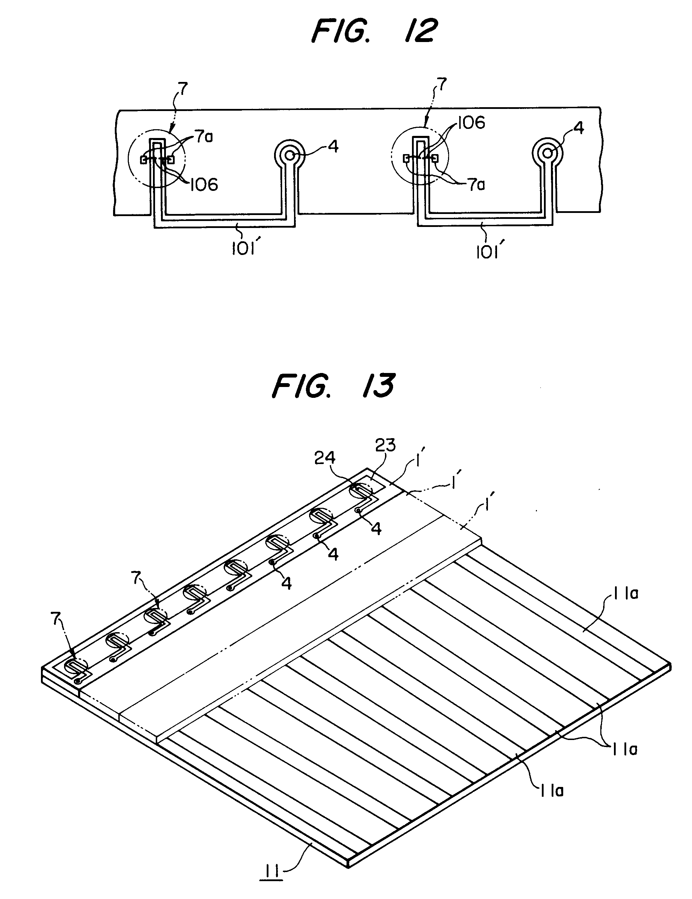

Fig. 11 illustrates the relationship of the display board 1 to the through-hole 200 of the flexible plate 2 in a vertical sectional structural diagram.

In the luminous display plate according to this embodiment of the present invention, no through-holes 4 are provided for the display board 1 in areas corresponding to the through-holes 200 of the flexible plate 2, and it will thus be readily understood that the through-holes 4 are formed in areas other than those where the through-holes 200 are made.

Fig. 12 is a diagram illustrating an electrode pattern of another example of the display board 1, wherein the through-hole 4 is made so that the semiconductor chips 7a bonded on the electrode X (Xₙ) are electrically wire-bonded to the electrode pattern 101' extending to the luminous portion 7, and consequently the through-hole 4 is seen to be provided in an area other than that where the through-hole 200 of the flexible plate 2 is made.

As set forth above, the present invention is characterized in that the through-holes 4 and 40 to 48 are provided in areas other than those corresponding to the through-holes 200 of the flexible plate 2.

Substantially any structure of the flexible plate 2 is acceptable, but it is preferred, as in the case of the first-described embodiment, to prevent the formation of strains and cracks by employing a material whose coefficient of thermal expansion conforms to that of the display board 1, or one prepared from a flexible resin, if the flexible plate 2 is selected in terms of its structural properties.

The present invention is not limited to dot matrix luminous displays as described above and, as proposed in Japanese Patent No. 59-27606, is applicable to a plurality of display boards provided with luminous portions forming a body of segments. Fig. 13 illustrates such an embodiment.

Specifically, Fig. 13 shows an arrangement of a body of segments 1' provided with luminous portions 7 and an insulating board 11 carrying an electrode pattern 11a, wherein the electrode pattern portion 24 of the body of segments 1' is connected to the electrode pattern 11a via through-holes 105 provided in areas other than those (shown by alternating long and two dashed lines) corresponding to the through-holes 200 of the flexible plate 2. The flexible plate 2 has been omitted in Fig. 13.

## Claims

1. A dot matrix luminous display comprising:
a dot matrix display board (1) having an insulating plate (110);
first and second sets of electrodes (100, 101) provided on respective opposite surfaces of said insulating plate (110);
a plurality of light emitting-elements (105; 7) and a plurality of through holes (109) through which said light emitting-elements (105; 7) are electrically coupled between said electrodes (100, 101) of said first and second sets, respectively;
and a member (2) provided over said one surface of said dot matrix display board (1), said member (2) having a plurality of through-holes (200) formed at locations corresponding to locations of said light-emitting elements (105; 7),
characterized in
that said member (2) is elastic, consists of silicon rubber, neoprene rubber, flexible epoxy resin or flexible acrylic resin, and is flexible relative to that dot matrix display board (1) and
that said through-holes (200) of said elastic member (2) being filled with a thermosetting resin (107), wherein contraction of said thermosetting resin (107) resulting from hardening of said thermosetting, resin (107) is absorbed by said elastic member (2).

2. A dot matrix luminous display of claim 1, wherein said through-holes (200) in said elastic member (2) are formed therein at locations corresponding to locations of said light emitting elements (105).

3. The luminous display of claim 1, wherein said through-holes (4) in said dot matrix display board (1) and said through-holes (200) in said elastic member (2) are offset from each other.

4. The luminous display of claims 1 or 2, wherein said dot matrix display board comprises: a plurality, of through-holes (109) formed in said insulating plate (1); said electrodes (100,101) of said first and second sets intersecting at said through-holes (109) in said insulating plate (110); a plurality of light-emitting elements (105) provided to said insulating plate (1), at least one of said light-emitting elements (105) being provided at each intersection of said electrodes (100,101) of said first and second sets, and each of said light-emitting elements (105) being electrically coupled to the intersecting ones of said electrodes (100,101) of said first and second sets.

5. The luminous display of claim 1 or 3, wherein said dot matrix display board comprises: an insulating plate having a plurality of through-holes formed therein; and a plurality of light emitting elements (7) provided to the first surface of said insulating plate; said through-holes (4;105) being adapted to allow one of said sets of first and second electrodes (100,101) to pass therethrough so as to electrically contact with said light emitting elements (7) on the first surface of said insulating plate where said light emitting elements (7) and the other one of said sets of first and second electrodes are provided.

6. The luminous display of claims 1-5, wherein said elastic member (2) is made of a heat resistant material.

7. The luminous display of claims 1-6, wherein said through-holes (200) in said elastic member (2) are filled with a translucent resin.

8. The luminous display of claims 1-7, wherein said insulating plate (109;11) is a glass epoxy laminated plate.

9. The luminous display of claim 1-7, wherein said insulating plate (109;11) is a paper phenol laminated plate.

10. The luminous display of claims 1-9, wherein inner walls of said through-holes (200) in said elastic plate (2) are of a reflective color.

## Patentansprüche

1. Eine Punktmatrix-Leuchtanzeige mit:
einer Punktmatrix-Anzeigetafel (1), die eine Isolierplatte (110) aufweist;
ersten und zweiten Sätzen von Elektroden (100, 101), die an entsprechend gegenüberliegend angeordneten Oberflächen der Isolierplatte (110) vorgesehen sind;
einer Mehrzahl von lichtemittierenden Elementen (105; 7) und einer Mehrzahl von Durchgangslöchern (109), durch welche die lichtemittierenden Elemente (105; 7) zwischen den Elektroden (100, 101) der ersten bzw. zweiten Sätze elektrisch gekoppelt sind;
und einem Teil (2), das über der einen Oberfläche der Punktmatrix-Anzeigetafel (1) vorgesehen ist, wobei das Teil (2) mehrere darin ausgebildete Durchgangslöcher (200) an Stellen aufweist, die den Stellen der lichtemittierenden Elemente (105; 7) entsprechen,
dadurch gekennzeichnet,
daß das Teil (2) elastisch ist, aus Silikon-Kautschuk, Neopren-Kautschuk, elastischem Epoxyharz oder elastischem Acrylharz besteht und relativ zu der Punktmatrix-Anzeigetafel (1) flexibel bzw. verbiegbar ist und daß die Durchgangslöcher (200) des elastischen Teils (2) mit einem wärmehärtenden Harz (107) gefüllt sind, wobei die aus der Härtung des wärmehärtenden Harzes (107) resultierende Kontraktion des wärmehärtenden Harzes (107) von dem elastischen Teil (2) absorbiert wird.

2. Punktmatrix-Anzeigetafel nach Anspruch 1, dadurch gekennzeichnet, daß die Durchgangslöcher (200) in dem elastischen Teil (2) darin an Stellen ausgebildet sind, die Stellen der lichtemittierenden Elemente (105) entsprechen.

3. Leuchtanzeige nach Anspruch 1, dadurch gekennzeichnet, daß die Durchgangslöcher (4) in der Punktmatrix-Anzeigetafel (1) und die Durchgangslöcher (200) in dem elastischen Teil (2) zueinander versetzt sind.

4. Leuchtanzeige nach Anspruch 1 oder 2, dadurch gekennzeichnet, daß die Punktmatrix-Anzeigetafel umfaßt:
mehrere in der Isolierplatte (1) ausgebildete Durchgangslöcher (109); wobei die Elektroden (100, 101) der ersten und zweiten Sätze sich an den Durchgangslöchern (109) in der Isolierplatte (110) schneiden; mehrere lichtemittierende Elemente (105), die an der Isolierplatte (1) vorgesehen sind, wobei wenigstens eines der lichtemittierenden Elemente (105) an jeder Schnittstelle der Elektroden (100, 101) der ersten und zweiten Sätze vorgesehen ist und jedes der lichtemittierenden Elemente (105) elektrisch mit den Schneidenden der Elektroden (100, 101) der ersten und zweiten Sätze gekoppelt ist.

5. Leuchtanzeige nach Anspruch 1 oder 3, dadurch gekennzeichnet, daß die Matrix-Anzeigetafel umfaßt:
eine Isolierplatte mit einer Mehrzahl an darin ausgebildeten Durchgangslöchern; und eine Mehrzahl von an der ersten Oberfläche der Isolierplatte vorgesehenen lichtemittierenden Elemente (7); wobei die Durchgangslöcher (4; 105) derart angepaßt sind, daß sie es einem der Sätze von ersten und zweiten Elektroden (100, 101) gestatten, durch sie hindurchzutreten um elektrisch mit den lichtemittierenden Elementen (7) auf der ersten Oberfläche der Isolierplatte elektrisch zu kontaktieren, wo die lichtemittierenden Elemente (7) und der andere, der Sätze von ersten und zweiten Elektroden vorgesehen ist.

6. Leuchtanzeige nach Anspruch 1 bis 5, dadurch gekennzeichnet, daß das elastische Teil (2) aus einem hitzeresistenten Material besteht.

7. Leuchtanzeige nach Anspruch 1 bis 6, dadurch gekennzeichnet, daß die Durchgangslöcher (200) in dem elastischen Teil (2) mit einem lichtdurchlässigen Harz gefüllt sind.

8. Leuchtanzeige nach Anspruch 1 bis 7, dadurch gekennzeichnet, daß die Isolierplatte (109; 11) eine glasepoxydlaminierte Platte ist.

9. Leuchtanzeige nach Anspruch 1 bis 7, dadurch gekennzeichnet, daß die Isolierplatte (109; 11) eine papierphenollaminierte Platte ist.

10. Leuchtanzeige nach Anspruch 1 bis 9, dadurch gekennzeichnet, daß die inneren Wände der Durchgangslöcher (200) in der elastischen Platte (2) von reflektierender Farbe sind.

## Revendications

1. Afficheur lumineux à matrice de points, comprenant :
un panneau d'affichage (1) à matrice de points ayant une plaque isolante (110),
un premier et un second ensemble d'électrodes (100, 101) placés sur les surfaces respectives opposées de la plaque isolante (110),
plusieurs éléments photoémissifs (105 ; 7) et plusieurs trous débouchants (109) par lesquels les éléments photoémissifs (105 ; 7) sont couplés électriquement entre lesdites électrodes (100, 101) du premier et du second ensemble respectivement, et
un organe (2) placé sur la première surface du panneau d'affichage (1) à matrice de points, ledit organe (2) ayant plusieurs trous débouchants (200) formés à des emplacements correspondant à des emplacements des éléments photoémissifs (105 ; 7),
caractérisé en ce que
ledit organe (2) est élastique, il est formé de caoutchouc de silicone, de caoutchouc de néoprène, de résine époxyde souple ou de résine acrylique souple, et il est souple par rapport au panneau d'affichage (1) à matrice de points, et
les trous débouchants (200) de l'organe élastique (2) sont remplis d'une résine thermodurcissable (107), la contraction de la résine thermodurcissable (107) résultant du durcissement de la résine thermodurcissable (107) étant absorbée par l'organe élastique (2).

2. Afficheur lumineux à matrice de points selon la revendication 1, dans lequel les trous débouchants (200) de l'organe élastique (2) sont formés à des emplacements correspondant aux emplacements des éléments photoémissifs (105).

3. Afficheur lumineux selon la revendication 1, dans lequel les trous débouchants (4) du panneau d'affichage (1) à matrice de points et les trous débouchants (200) de l'organe élastique (2) sont décalés mutuellement.

4. Afficheur lumineux selon la revendication 1 ou 2, dans lequel le panneau d'affichage à matrice de points comprend plusieurs trous débouchants (109) formés dans la plaque isolante (1), les électrodes (100, 101) du premier et du second jeu se recoupent au niveau des trous débouchants (109) formés dans la plaque isolante (110), plusieurs éléments photoémissifs (105) sont disposés sur la plaque isolante (1), l'un au moins des éléments photoémissifs (105) étant placé à chaque intersection des électrodes (100, 101) du premier et du second ensemble, et chacun des éléments photoémissifs (105) étant couplé électriquement aux électrodes (100, 101) du premier et du second ensemble qui se recoupent.

5. Afficheur lumineux selon la revendication 1 ou 3, dans lequel le panneau d'affichage à matrice de points comporte une plaque isolante ayant plusieurs trous débouchants, et plusieurs éléments photoémissifs (7) placés à la première surface de la plaque isolante, les trous débouchants (4 ; 105) étant destinés à permettre le passage de l'un des ensembles de premières électrodes et des secondes électrodes (100, 101) afin que celles-ci soient en contact électrique avec les éléments photoémissifs (7) à la première surface de la plaque isolante sur laquelle sont placés les éléments photoémissifs (7) et l'autre des ensembles des premières électrodes et des secondes électrodes.

6. Afficheur lumineux selon les revendications 1 à 5, dans lequel l'organe élastique (2) est formé d'un matériau résistant à la chaleur.

7. Afficheur lumineux selon les revendications 1 à 6, dans lequel les trous débouchants (200) formés dans l'organe élastique (2) sont remplis d'une résine translucide.

8. Afficheur lumineux selon les revendications 1 à 7, dans lequel la plaque isolante (109 ; 11) est une plaque stratifiée de résine époxyde armée de verre.

9. Afficheur lumineux selon les revendications 1 à 7, dans lequel la plaque isolante (109 ; 11) est une plaque stratifiée de papier et phénolique.

10. Afficheur lumineux selon les revendications 1 à 9, dans lequel les parois internes des trous débouchants (200) de la plaque élastique (2) ont une couleur réfléchissante.
